# EUROPEAN PATENT APPLICATION

(11) **EP 3 334 002 A1**
(43) Date of publication of application: **13.06.2018**
(21) Application number: 17204954.6
(22) Date of filing: 01.12.2017
(51) Int. Cl.: H02J 7/00

(54) **BATTERY CHARGING STATION WITH MODULE PORT**

(30) Priority: 02.12.2016 US 201662429579 P
(71) Applicant: TTI (Macao Commercial Offshore) Limited, Macao (MO)
(72) Inventor: Huggins, Mark, Anderson, South Carolina 29621 (US); Preus, Michael, Piedmont, South Carolina 29673 (US); Asher, Matthew, Anderson, South Carolina 29625 (US)
(74) Representative: Dauncey, Mark Peter

(57) **Abstract**

An accessory device system includes a charger, a battery pack selectively coupled to a battery receiving portion of the charger to receive charging current, and a first accessory device selectively coupled to an accessory device port of the charger. The charger further includes an electronic controller having a wireless transceiver and configured to communicate with a peripheral device to one or more of provide identity and status information regarding the first accessory device and to receive settings data to control the first accessory device. The charger receives the identity and status information from the first accessory device, and provides the settings data to the first accessory device to control the first accessory device. In some instances, the peripheral device and the charger communicate via a network and server, and the charger communicates wirelessly with the network via the wireless transceiver.

## Description

### FIELD OF THE INVENTION

The present invention relates to a battery charging device, and more particularly to a battery charging device including electromechanical ports for accessory devices.

### SUMMARY OF THE INVENTION

The present invention provides, in one aspect, an accessory device system including an accessory device, a garage door opener including a first accessory device port configured to couple to the accessory device and provide power to the accessory device via the first accessory device port, and a charger. The charger includes a second accessory device port configured to couple to the accessory device, and a battery receiving portion configured to be selectively coupled to a battery pack and to charge the battery pack. The charger is configured to provide power to the first accessory device via the second accessory device port.

The present invention provides, in one aspect, a method of operating an accessory device system including a garage door opener, a charger, and an accessory device. The method includes receiving, by a first accessory device port on the garage door opener, the accessory device. The garage door opener provides power to the accessory device via the first accessory device port. The first accessory device port then disconnects from the accessory device and the accessory device is received by a second accessory device port on the charger. The charger then provides power to the accessory device via the second accessory device port.

The present invention provides, in one aspect, a method of operating an accessory device system including an accessory device. The method includes receiving the accessory device by an accessory device port on a charger that is portable and non-motorized. The charger provides power to the accessory device via the accessory device port and receives via the identity and status data from the accessory device. An electronic controller of the charger having a wireless transceiver sends the identity and status data regarding the accessory device to a peripheral device and receives settings data regarding the accessory device from the peripheral device. The charger provides the settings data to the accessory device to control the accessory device.

Another embodiment provides an accessory device system comprising: an accessory device; a garage door opener including a first accessory device port configured to couple to the accessory device and provide power to the accessory device via the first accessory device port; and a charger including a second accessory device port configured to couple to the accessory device, and a battery receiving portion configured to be selectively coupled to a battery pack and to provide charging power to the battery pack, wherein the charger is configured to provide power to the accessory device via the second accessory device port.

The battery pack may be a power tool battery pack having a battery cell with at least one selected from the group consisting of nickel cadmium chemistry and lithium ion chemistry.

The charger may further include an electronic controller having a wireless transceiver and configured to: communicate with a peripheral device to one or more of provide identity and status information regarding the accessory device and to receive settings information to control the accessory device, receive the identity and status information from the accessory device, and provide the settings information to the accessory device to control the accessory device.

The charger may further include an AC outlet port and a DC outlet port, or the charger may further include a third accessory device port configured to couple to a second accessory device, and the charger may be configured to provide power to the second accessory device via the third accessory device port.

The charger may further include an electronic controller having a wireless transceiver and configured to: communicate with a peripheral device to one or more of provide identity and status information regarding the accessory device and the second accessory device and to receive settings information to control the accessory device and the second accessory device, receive the identity and status information from the accessory device and the second accessory device, and provide the settings information to the accessory device and second accessory device to control the accessory device and the second accessory device.

The accessory device may be at least one selected from the group consisting of a wireless speaker, a fan, or a light, or the accessory device may be a first accessory device and the system further comprises a second accessory device configured to couple to the first accessory device port and to the second accessory device port.

Another embodiment provides a method of operating an accessory device system including a garage door opener, a charger, and an accessory device, the method comprising: receiving, by a first accessory device port on the garage door opener, the accessory device; providing, by the garage door opener, power to the accessory device via the first accessory device port; disconnecting, by the first accessory device port, from the accessory device; receiving, by a second accessory device port on the charger, the accessory device; and providing, by the charger, power to the accessory device via the second accessory device port.

The method may further comprise: receiving, by a battery receiving portion of the charger, a battery pack; and charging, by the charger, the battery pack.

The battery pack may be a power tool battery pack having a battery cell with at least one selected from the group consisting of nickel cadmium chemistry and lithium ion chemistry.

The method may further comprise: receiving, by a third accessory device port on the charger, a second accessory device after disconnecting the accessory device; and providing, by the charger, power to the second accessory device via the third accessory device port.

The accessory device may be at least one selected from the group consisting of a wireless speaker, a fan, or a light.

A further embodiment provides a method of operating an accessory device system including an accessory device, the method comprising: receiving the accessory device by an accessory device port on a charger that is portable and non-motorized; providing, by the charger, power to the accessory device via the accessory device port; receiving, via the charger, identity and status data from the accessory device; sending, by an electronic controller of the charger having a wireless transceiver, the identity and status data regarding the accessory device to a peripheral device; receiving, by the electronic controller, settings data regarding the accessory device from the peripheral device; and providing, via the charger, the settings data to the accessory device to control the accessory device.

The method may further comprise: receiving, by a battery receiving portion of the charger, a battery pack; and charging, by the charger, the battery pack.

The battery pack may be a power tool battery pack having nickel cadmium cell chemistry or lithium ion chemistry, or the accessory device may be a wireless speaker, a fan, or a light, and the identity data may indicate that the accessory device is a wireless speaker, a fan, or a light, or the peripheral device and the charger may communicate via a network and server, or the charger may communicate wirelessly with the network via the wireless transceiver.

The method may further comprise: disconnecting, by the accessory device port, from the accessory device; receiving, by the accessory device port, a second accessory device; providing, by the charger, power to the second accessory device via the accessory device port; receiving, by the charger via the accessory device port, second identity and status data from the second accessory device; sending, by the electronic controller, the second identity and status data regarding the second accessory device to the peripheral device; receiving, by the electronic controller, second settings data regarding the second accessory device from the peripheral device; and providing, via the charger, the second settings data to the second accessory device to control the second accessory device.

Other features and aspects of the invention will become apparent by consideration of the following detailed description and accompanying drawings.

### BRIEF DESCRIPTION OF THE DRAWINGS

FIG. 1 is a view of a garage door opener system.
FIG. 2 is a view of a garage door opener of the garage door system in FIG. 1.
FIG. 3 is a block power diagram of the garage door opener of FIG. 2.
FIG. 4 is a block communication diagram of the garage door opener of FIG. 2.
FIG. 5 is a side view of a housing of the garage door opener system of FIG. 1.
FIG. 6 is a front perspective view of an accessory device for use with the garage door opener system of FIG. 1.
FIG. 7 is a rear perspective view of the accessory device of FIG. 6.
FIG. 8A is a top view of a charger.
FIG. 8B is a view of an accessory receiving port of the charger of FIG. 8A.
FIG. 9 is a block diagram of the charger of FIG. 8A.
FIG. 10 is another block diagram of the charger of FIG. 8A.
FIG. 11 is a view of a battery pack that may be coupled to the charger of FIG. 8A in some embodiments.
FIG. 12 is a block diagram of the battery pack of FIG. 11.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting.

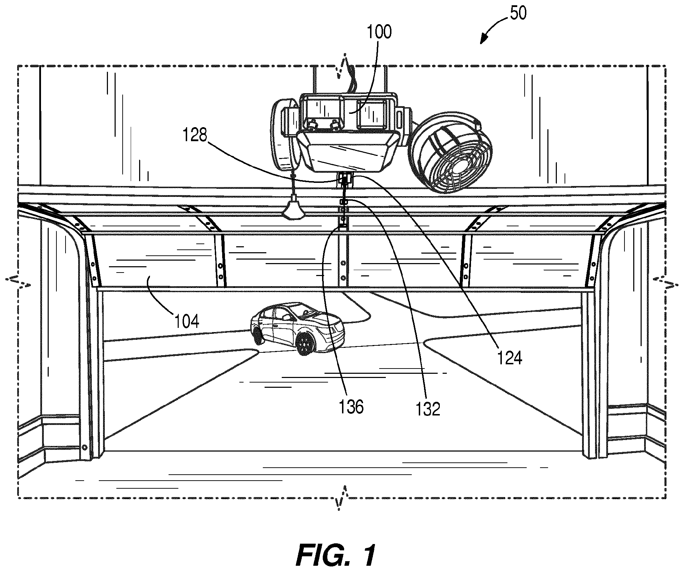

FIGS. 1-2 illustrate a garage door system 50 including a garage door opener 100 operatively coupled to a garage door 104. The garage door opener 100 includes a housing 108 supporting a motor that is operatively coupled to a drive mechanism 116. The drive mechanism 116 includes a transmission coupling the motor to a drive chain 120 having a shuttle 124 configured to be displaced along a rail assembly 128 upon actuation of the motor. The shuttle 124 may be selectively coupled to a trolley 132 that is slidable along the rail assembly 128 and coupled to the garage door 104 via an arm member.

The trolley 132 is releaseably coupled to the shuttle 124 such that the garage door system 50 is operable in a powered mode and a manual mode. In the powered mode, the trolley 132 is coupled to the shuttle 124 and the motor is selectively driven in response to actuation by a user (e.g., via a key pad or wireless remote in communication with the garage door opener 100). As the motor is driven, the drive chain 120 is driven by the motor along the rail assembly 128 to displace the shuttle 124 (and, therefore, the trolley 132), thereby opening or closing the garage door 104. In the manual mode, the trolley 132 is decoupled from the shuttle 124 such that a user may manually operate the garage door 104 to open or close without resistance from the motor. The trolley 132 may be decoupled, for example, when a user applies a force to a release cord 136 to disengage the trolley 132 from the shuttle 124. In some embodiments, other drive systems are included such that, for example, the drive mechanism 116 includes a transmission coupling the motor to a drive belt that is operatively coupled to the garage door 104 via a rail and carriage assembly.

The housing 108 is coupled to the rail assembly 128 and a surface above the garage door (e.g., a garage ceiling or support beam) by, for example, a support bracket 148. The garage door opener further includes a light unit 152 including a light (e.g., one or more light emitting diodes (LEDs)) enclosed by a transparent cover or lens 156), which provides light to the garage. The light unit 152 may either be selectively actuated by a user or automatically powered upon actuation of the garage door opener 100. In one example, the light unit 152 may be configured to remain powered for a predetermined amount of time after actuation of the garage door opener 100.

The garage door opener 100 further includes an antenna 158 enabling the garage door opener 100 to communicate wirelessly with other devices, such as a smart phone or network device (e.g., a router, hub, or modem), as described in further detail below. The garage door opener 100 is also configured to receive, control, and/or monitor a variety of accessory devices or modules, such as a backup battery unit 189, a speaker 192, a fan 194, an extension cord reel 196, among others.

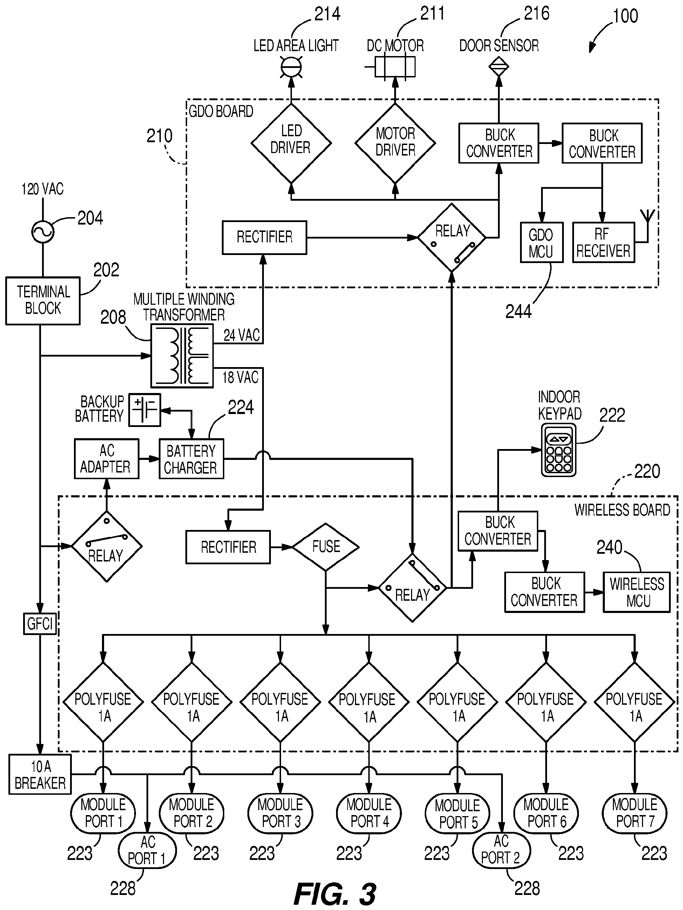

FIG. 3 illustrates a block power diagram of the garage door opener 100. The garage door opener 100 includes a terminal block 202 configured to receive power from an external power source 204, such as a standard 120 VAC power outlet. The terminal block 202 directs power, via a transformer 208, to a garage door opener (GDO) board 210 for supply to components thereof as well as a motor 211 (used to drive the drive mechanism 116, as described above), LEDs 214 (of the light unit 152), and garage door sensors 216. The terminal block 202 further directs power via the transformer 208 to a wireless board 220 and components thereof, as well as a wired keypad 222 and module ports 223. The terminal block 202 also directs power to a battery charger 224 and AC ports 228. The module ports 223 are configured to receive various accessory devices, such as a speaker, a fan, an extension cord reel, a parking assist laser, an environmental sensor, a flashlight, and a security camera. One or more of the accessory devices are selectively attachable to and removable from the garage door opener 100, and may be monitored and controlled by the garage door opener 100.

The wireless board 220 includes a wireless microcontroller 240, among other components. The GDO board 210 includes, among other components, a garage door opener (GDO) microcontroller 244 and a radio frequency (RF) transceiver 246.

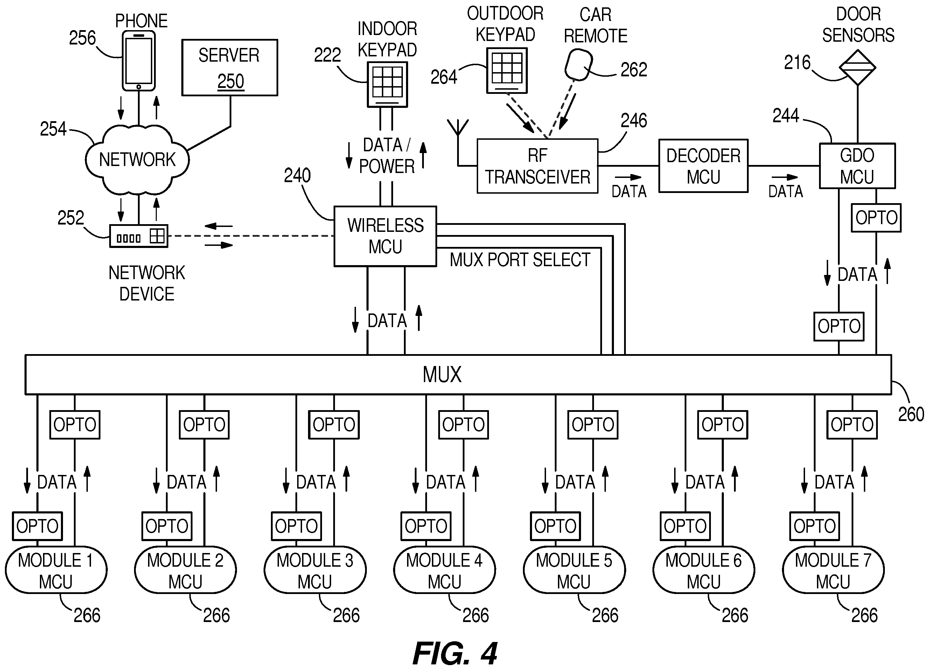

FIG. 4 illustrates a block communication diagram of the garage door opener 100. The wireless microcontroller 240 is coupled to the antenna 158 and enables wireless communication with a server 250 via a network device 252 and network 254, as well as with a smart phone 256 (and other similar external devices, such as tablets and laptops). The network device 252 may be, for example, one or more of a router, hub, or modem. The network 254 may be, for example, the Internet, a local area network (LAN), another wide area network (WAN) or a combination thereof. The wireless microcontroller 240 may include, for example, a Wi-Fi radio including hardware, software, or a combination thereof enabling wireless communications according to the Wi-Fi protocol. In other embodiments, the wireless microcontroller 240 is configured to communicate with the server 250 via the network device 252 and network 254 using other wireless communication protocols. The network 254 may include various wired and wireless connections to communicatively couple the garage door opener 100 to the server 250. As illustrated, the wireless microcontroller 240 also includes wired communication capabilities for communicating with the GDO microcontroller 244 via the multiplexor 260. In some embodiments, the wireless microcontroller 240 and the GDO microcontroller 244 are directly coupled for communication. In some embodiments, the wireless microcontroller 240 and the GDO microcontroller 244 are combined into a single controller.

The RF transceiver 246 is wirelessly coupled to various user actuation devices, including one or more wireless remotes 262 and wireless keypads 264, to receive and provide to the GDO microcontroller 244 user actuation commands (e.g., to open and close the garage door 104). The smart phone 256 may also receive user input and, in response, provide (directly or via the network 254) to the wireless microcontroller 240 user actuation commands for the garage door opener 100 or commands to control one or more of the accessory devices. The multiplexor 260 enables communication between and among the wireless microcontroller 240, the GDO microcontroller 244, and the accessory microcontrollers 266 (of the accessory devices previously noted).

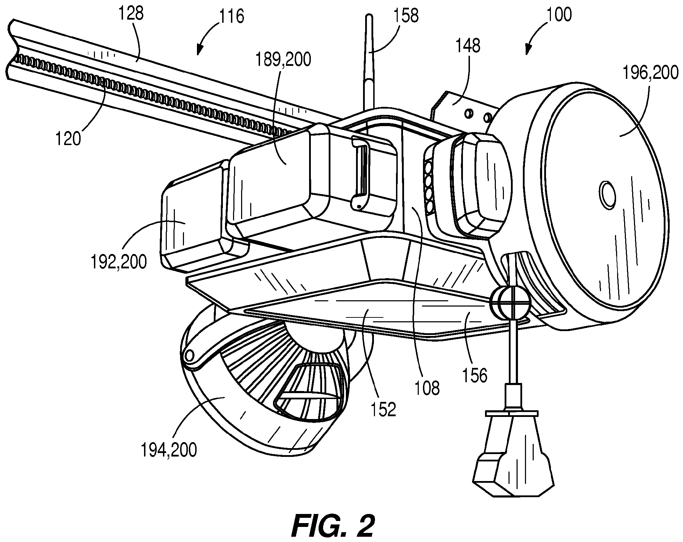

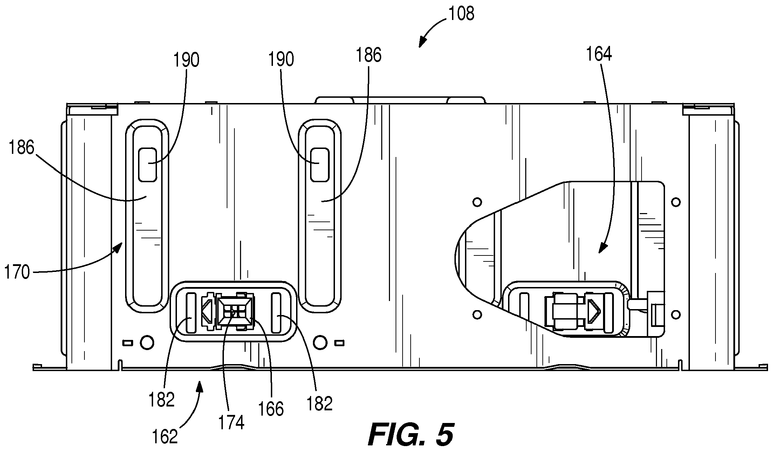

With reference to FIG. 5, the housing 108 includes accessory ports 162 that receive and support accessory devices, as noted above, which are modular, interchangeable accessory devices and are generically referred to as the accessory devices 200 (see, e.g., FIG. 2) In the illustrated embodiment, the housing 108 has eight accessory ports 162 with two ports 162 disposed on each side of the housing 108. However, this configuration is merely exemplary - that is, the housing 108 may include more than eight ports 162 or less than eight ports 162, and each side of the housing 108 may include more or less than two ports 162. Additionally, the housing 108 may include more or less than four sides with each having one or more ports 162, and other surfaces of the housing (e.g., the top and bottom) may include one or more ports 162.

With continued reference to FIG. 5, each port 162 includes a communication interface 166 and a coupling interface 170. The communication interface 166 includes an electrical connector 174 disposed within a recess 178. The electrical connector 174 is configured to facilitate electrical communication and data communication between the accessory device 200 and the garage door opener 100. The electrical connector 174 may be any type of powered input/output port. Additionally, in further embodiments the electrical connector 174 may define separate power connectors and data connectors, which may similarly be any type of power connectors and data connectors. In the illustrated embodiment, two slots 182 are formed on either side of the electrical connector 174 and receive a portion of an accessory device 200 to align and mechanically couple the accessory device 200 with housing 108. The coupling interface 170 is defined by a pair of spaced apart, raised surfaces 186 defined on either side of the communication interface 166. Each raised surface 186 includes a chamfered edge and has an aperture 190 defined there through. However, the raised surfaces 186 may be omitted in other embodiments. The apertures 190 are configured to receive portions of the accessory devices 200 to facilitate mechanical coupling of the accessory device 200 to the garage door opener 100.

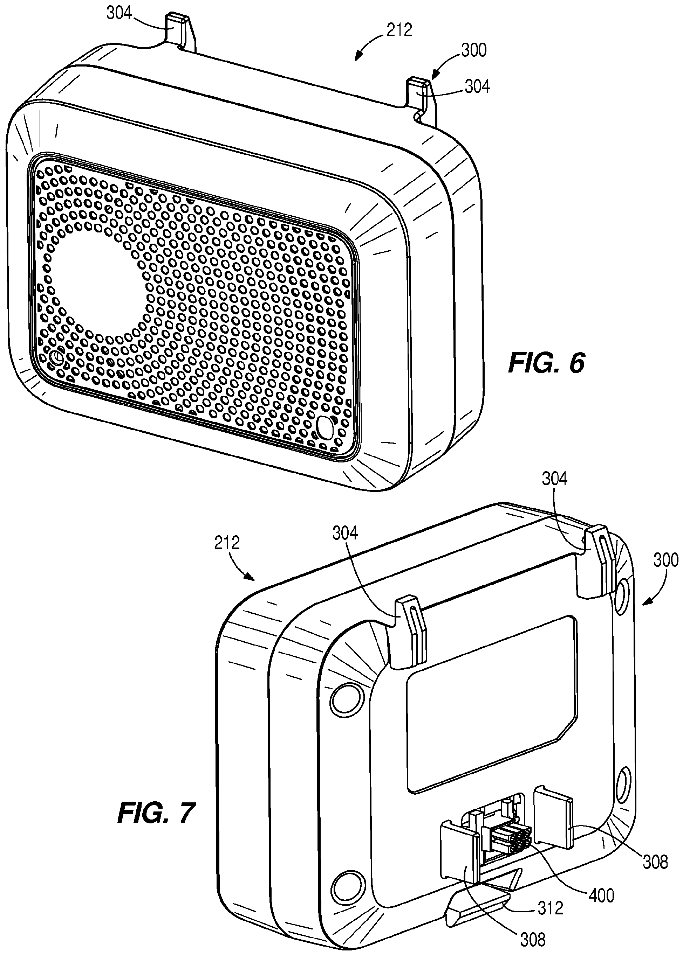

FIGS. 6 and 7 illustrate an example of one of the accessory devices 200 - an accessory speaker 212 - that is configured to be detachably coupled to the garage door opener 100. In the illustrated embodiment, the speaker 212 is a wireless speaker 212 (e.g., a Bluetooth® speaker) that may be wirelessly coupled to a peripheral device, such as the smart phone 256 or a tablet. In one embodiment, the speaker 212 receives an audio stream from the peripheral device communicating with the garage door opener 100, and subsequently drives a speaker 212 to output the audio stream using power from the garage door opener 100 via an electrical mounting interface 400. In another embodiment, the wireless speaker 212 receives an audio stream wirelessly directly from the peripheral device via an integral transceiver, and drives a speaker 212 to output the audio stream using power from the garage door opener 100 via the electrical mounting interface 400.

With reference to FIG. 7, the speaker 212 includes a mechanical mounting interface 300 configured to be coupled to the coupling interface 170 of the housing 108, and the electrical mounting interface 400 configured to be coupled to the communication interface 166 of the housing 108. The mechanical mounting interface 300 includes a pair of hooks 304 that are received within the apertures 190 of the coupling interface 170, a pair of projections 308 disposed on opposing sides of the electrical mounting interface 400, and at least one protruding latch member 312 configured to engage a corresponding retention member on the housing 108. The projections 308 are configured to be received within the slots 182 to assist with alignment of the electrical mounting interface 400 and the communication interface 166. When coupled, the speaker 212 receives power from the garage door opener 100 via a connection defined by the electrical mounting interface 400 and the communication interface 166. The speaker 212 also sends data to and receives data from the garage door opener 100 via a connection defined by the electrical mounting interface 400 and the communication interface 166.

The speaker 212 further includes a controller (e.g., microcontroller 266) in communication with the wireless microcontroller 240 of the garage door opener 100. The controller includes a memory storing an initial data set including a unique identifier, a predetermined initial status field, and a predetermined initial settings field that is communicated to the garage door opener 100 each time the speaker 212 is coupled to the port 162. Thereafter, the controller is configured to send and receive data from, for example, the server 250 via the wireless microcontroller 240. More specifically, the controller receives updates to the settings field of the data set based on data received from the wireless microcontroller 240. The controller also updates the status field of the data set, which is sent to the wireless microcontroller 240 for communication to the peripheral device via the server 250.

In one embodiment, the status field includes, for example, on/off state of the speaker, the pairing status (e.g., Bluetooth® pairing status), and speaker volume, among others. The settings field includes an on/off toggle, a pairing toggle (e.g., to turn pairing on/off), and a volume value, among others. In this example, the user may set the values for the settings field (e.g., via the smart phone 256 or other peripheral device), which updates the speaker 212 to turn on/off, turn pairing on/off, or alter the volume of the speaker. For example, the smart phone 256 may communicate updated settings for the settings field on the server 250. In turn, for example, the server 250 sends the updated settings to the speaker 212 via the network 254, network device 252, and wireless microcontroller 240.

Each of the accessory devices 200 may be interchangeably coupled to the ports 162 of the housing 108 due to the common mechanical mounting interfaces 300 and electrical mounting interfaces 400. In other words, each accessory device 200 may be coupled to any port 162 on the housing. This modular design allows a user to couple desired accessory devices 200 to the garage door opener 100 in a preferred location, while removing accessory devices 200 that the user does not require. This modular design allows the user to customize the garage door opener 100 to fit their specific needs.

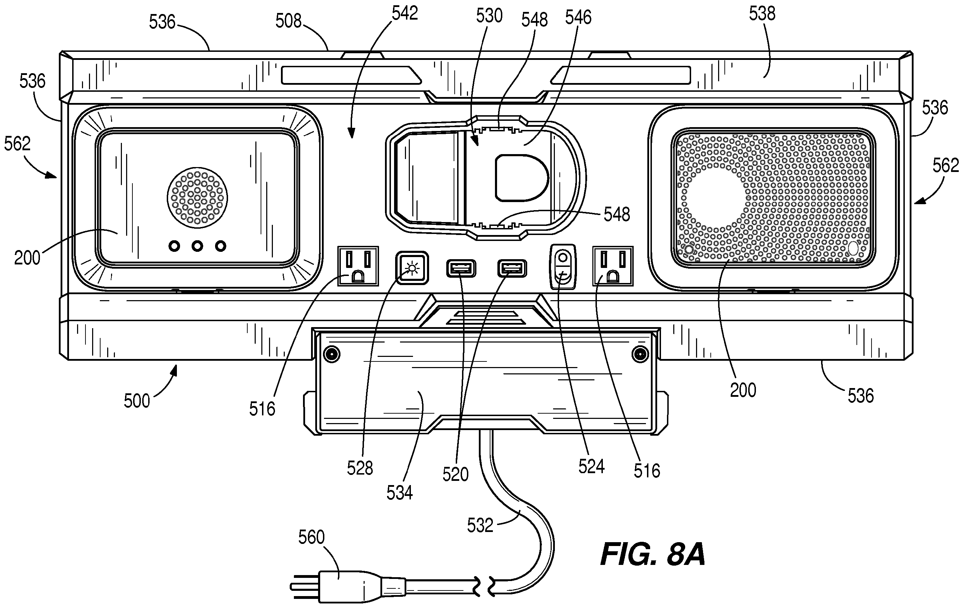

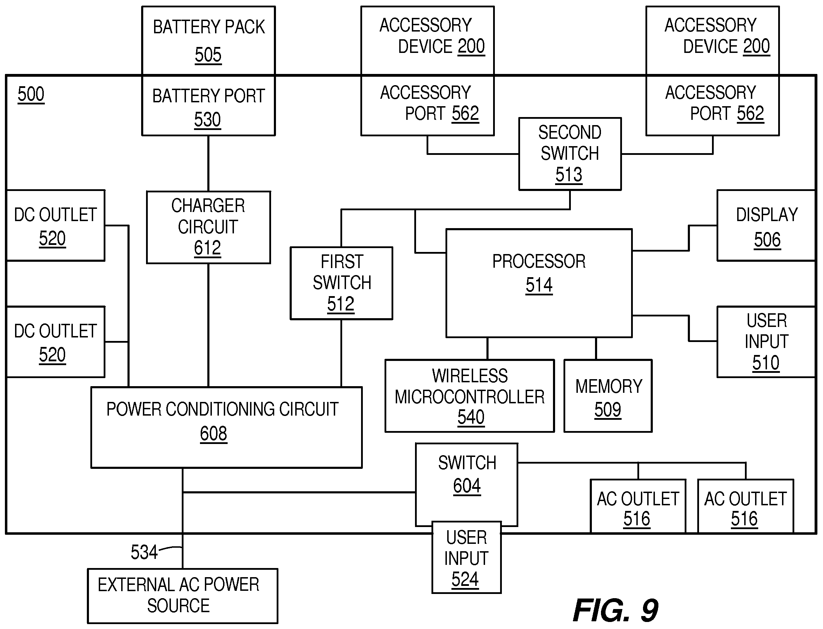

FIGS. 8A-B and 9 illustrate a charger 500 that includes a housing 508 defining at least one battery receiving port 530, at least one accessory device receiving port or accessory port 562, at least one AC power outlet 516, at least one DC power outlet 520, a user input 524, a light or indicator 528, and a power cord 532 configured to be connected to an external power source. In the illustrated embodiment, the housing 508 is configured as a rectangular housing 508 including a lower support face configured to support the housing on a surface (not shown), four sidewalls 536, and a port face 538 opposite the support face that includes a port groove 542 defined therein. The port groove 542 includes the battery receiving port 530 disposed in a central location on the port face 538 with two accessory device receiving ports 562 disposed on either side of the battery receiving port 530 (e.g., to the left and to the right in FIG. 8A). Two DC power outlets 520 are defined in the port groove 542 adjacent the battery receiving port 530 between the accessory device receiving ports 562. Two AC power outlets 516 are defined in the port groove 542 adjacent the battery receiving port 530 between the accessory device receiving ports 562, such that the AC power outlets 516 are each defined between one accessory device receiving port 562 and a DC power outlet 520. A light 528 and a user input 524 (e.g., a power switch) are also defined in the port groove 542. The spatial configuration of the charger 500 is exemplary and may be varied in other embodiments.

Although one configuration of the charger 500 was described with respect to FIG. 8A above, various modifications may be made to the illustrated charger 500. For example, the number of battery receiving ports 530, accessory device receiving ports 562, AC power outlets 516, DC power outlets 520, user inputs 524, and lights 528 may be varied in other embodiments. That is, the charger 500 may include two or more battery receiving ports 530, more or less than two accessory device receiving ports 562, more or less than two AC power outlets 516, more or less than two DC power outlets 520, more than one user input 524, and more than one light 528. The AC power outlets 516 are illustrated as standard 3-prong AC outlets 516. However, in other embodiments, the AC power outlets 516 may be any suitable AC power outlets. The DC power outlets 520 are illustrated as USB ports. However, in other embodiments, the DC power outlets 520 may be any suitable DC power outlets 520.

The charger 500, in contrast to the garage door opener 100, is a non-motorized device. In other words, the charger 500 does not include a motor within or supported by the housing 508 that supports the charging circuitry. Stated another way, the charger 500 and the housing 508 are independent of a motor because the charger does not include a motor within or supported by the housing 508 that supports the charging circuitry. Additionally, the charger 500 is portable between uses and not fixedly mounted to garage or other structure to open or close a garage door. For example, the charger 500 may include a carrying handle or handles in some embodiments, and one or more supporting feet on the lower support face extending downward from the housing 508 to support the housing 508 when the charger is resting on a support surface.

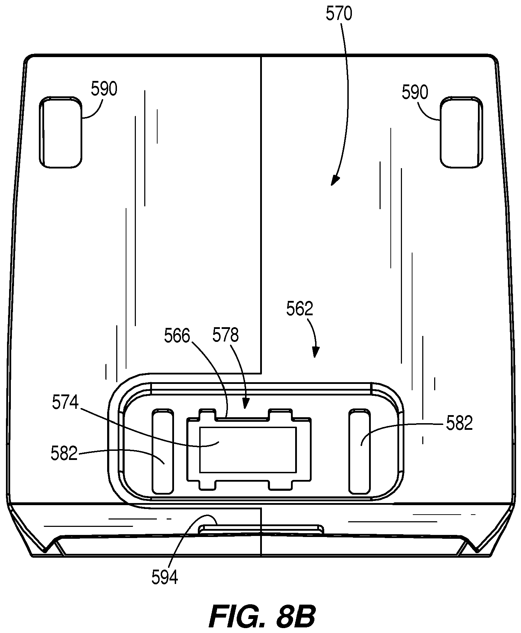

FIG. 8B illustrates an example of the accessory receiving port 562. As shown in FIG. 8B, the accessory receiving ports 562 are similar to the ports 162 disposed on the housing 108 such that the accessory receiving ports 562 can receive the same accessory devices 200 described above. Accordingly, the accessory port 562 includes a communication interface 566 and a coupling interface 570. The communication interface 566 includes an electrical connector 574 disposed within a recess 578 on a planar support surface. The electrical connector 574 is configured to facilitate electrical communication and data communication between the accessory device 200 and the charger 500 (e.g., to couple the accessory device 200 to a power source). The electrical connector 574 may be any type of powered input/output port. Additionally, in further embodiments the electrical connector 574 may define separate power connectors and data connectors, which may similarly be any type of power connectors and data connectors. Two slots 582 are formed on either side of the electrical connector 574 and receive a portion of an accessory device 200 to align and mechanically couple the accessory device 200 with housing 508.

The coupling interface 570 is defined by a pair of spaced apart apertures 590 disposed on an upper end of the support surface and a catch 594 defined in a groove. Each of the apertures 590 is configured to receive portions of the accessory devices 200 to facilitate mechanical coupling of the accessory device 200 to the charger 500. The catch 594 is configured to receive, for example, the latch 312 of the accessory device 200 to secure and maintain engagement of the accessory device 200 to the charger 500. In addition, the groove defines lower surfaces for supporting the accessory device 200.

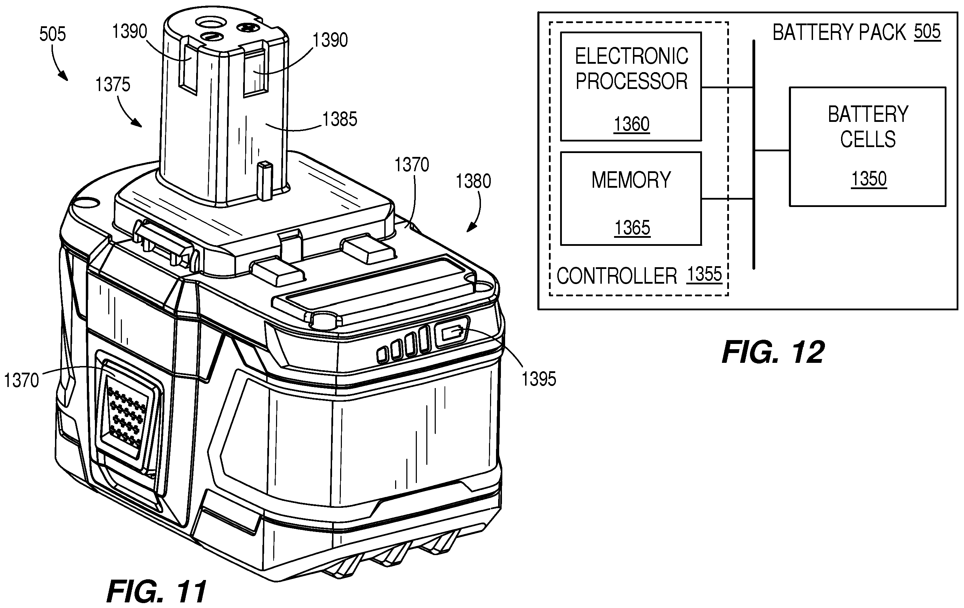

With reference to FIG. 8A, the battery receiving port 530 includes a recess 546 that is sized and shaped to receive a battery pack 505. The battery receiving portion 530 includes charger electrical contacts that are configured to mechanically and electrically engage battery contacts to communicate electrical power and/or data signals therebetween. In addition, the battery receiving portion 530 includes two slots 548 disposed on opposed sides of the recess 546 that are configured to receive battery pack latch members 1370 (see FIG. 11) to secure and maintain engagement of the battery pack 505 to the charger 500. In the illustrated embodiment, the battery receiving portion 530 is configured to receive a battery pack 505 that is inserted along a vertical insertion axis. However, in other embodiments, the battery receiving portion 530 may be configured to receive the battery pack 505 configured as a 'slide on' battery pack that is inserted along a horizontal insertion axis.

With reference to FIG. 8A, the power cord 532 is coupled to the housing 508 via a power cord housing 534. The power cord housing 534 is pivotally coupled to the charger housing 508 such that the power cord housing 534 is pivotal about a pivot axis. In some embodiments, the power cord housing 534 may be configured to support a length of excess power cord 532. In another embodiment, the power cord housing 534 may include, for example, a cord reel that automatically retracts and winds a length of excess power cord 532. In yet another embodiment, the power cord 532 may be directly coupled to the housing 508.

The power cord 532 itself includes a standard 3 prong male adapter 560 configured to be coupled to an external power source (e.g., a standard 120 VAC power outlet). However, in other embodiments, the power cord 532 may include other suitable adapters for coupling the charger to an external power source.

FIG. 9 illustrates a block diagram of the charger 500. As illustrated, the charger 500 includes the two AC power outlets 516 coupled to the external power source via a switch 604, a power conditioning circuit 608, two DC power outlets 520, a charger circuit 612 coupled to the battery receiving port 530, a processor 514, and two accessory device receiving ports 562 each interconnected by one or more bus connections. The switch 604 is configured to direct AC power from the external power source to the AC outlets 516 when the switch is closed. The switch 604 may be operated, for example, by user input 524 (e.g., toggle switch) disposed on the housing 508. In an alternate embodiment, the switch 604 may be two separate switches, each configured to direct power to an AC outlet 516 when the corresponding switch is closed.

The power conditioning circuit 608 is configured to receive and covert AC input from the external power source to a DC power output. The power conditioning circuit 608 may include, for example, one or more rectifiers, transformers, filters, etc to accomplish the conversion. After conversion, the DC power is directed to the DC outlets 520, the charger circuit 612, the processor 514, and the accessory device ports 562.

The charging circuit 612 is configured to control the flow of current to the battery pack 505 in order to charge the pack 505. The charging circuit 612 may include a processor that is configured to monitor battery pack properties (e.g., type of battery, charge state, temperature, number of charge cycles, etc.) to determine and execute a charging protocol stored in a memory of the charging circuit 612. The charging protocol may include a constant or variable current application, constant or variable voltage application, a programmed sequence of constant/variable current and constant/variable voltage, and automatic shut-off in response to monitored battery pack properties (e.g., at completed charge, a temperature threshold, etc.).

With continued reference to FIG. 9, charger 500 includes the processor 514 that is coupled to the power conditioning circuit 608, a memory 509, a wireless microcontroller 540, a user input 510, a display 506, and each of the accessory devices 200 via the accessory device receiving ports 562. The processor 514 executes software, which may be stored in the memory 509, to carry out the functionality of the charger 500 described herein. The user input 510 has at least one actuator (e.g., button, switch, lever, touchscreen, etc.) that is configured to control operation of the charger 500. In the illustrated embodiment, the user input 510 includes two actuators on an outside of the housing 508 (e.g., similar to the switch 524 and located on the port groove 542) that are each configured to operate a first switch 512 and a second switch 513, respectively. For example, the first switch 512 is disposed between the power conditioning circuit 608 and the processor 514 of the charger 500 as well as the accessory device 200 such that the first switch 512 controls the on/off state of the processor (i.e., whether power is supplied from the power conditioning circuit 608 to the processor 514). When the first switch 512 is closed, the power conditioning circuit 608 supplies DC power to the processor 514 to turn the charger 500 to an on or active state. The second switch 513 is disposed between the power conditioning circuit 608 and the accessory device 200 such that the second switch 513 controls the on/off state of the accessory device 200 coupled to accessory ports 562 (i.e., whether power supplied to the processor 514 from the power conditioning circuit 608 is passed to the accessory device 200). When the second switch 513 is closed, the power conditioning circuit 608 supplies DC power (received via the first switch 512 when the first switch 512 is closed) to at least one of the accessory devices 200. In other words, the charger 500 provides power to the accessory device 200 when both the first switch 512 and the second switch 513 are closed.

The first switch 512 and the second switch 513 are configured to be selectively actuated by the user (e.g., by a button, switch, lever, touchscreen, etc.). The actuators for the first switch 512 and the second switch 513 may physically open or close the first switch 512 and the second switch 513 upon actuation, or the actuator may communicate a control signal to the processor 514 of the charger 500 upon actuation, which causes the processor 514 to control the first switch or second switch to open or close.

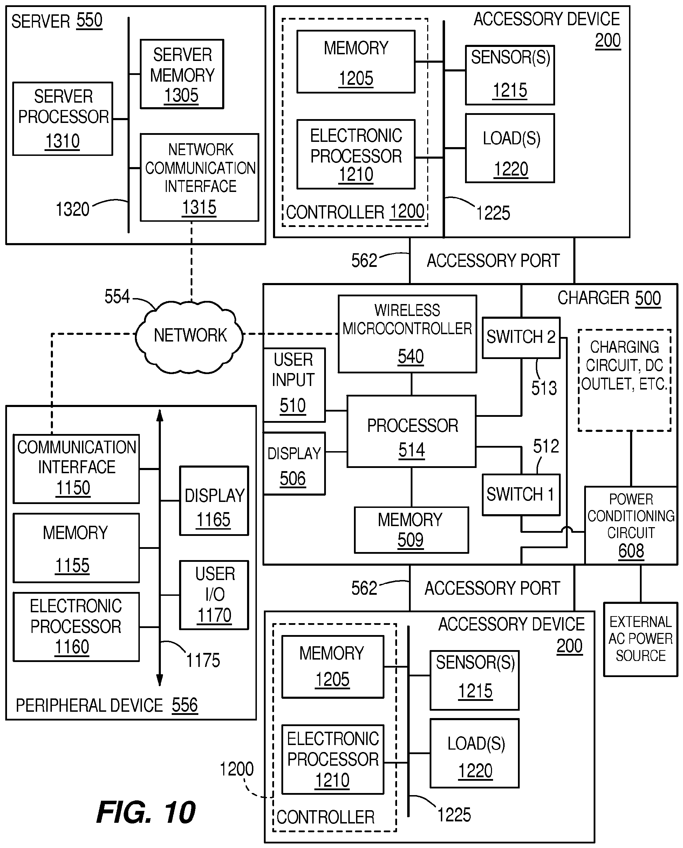

With reference to FIG. 10, the wireless microcontroller 540 enables wireless communication similar to the wireless microcontroller 240 described above with respect to the garage door opener 100. For example, the charger 500 is configured to wirelessly communicate via a network 554 with a server 550 and a peripheral device 556 (e.g., a smart phone, tablet, laptop, or the like). The network 554 may be, for example, the Internet, a local area network (LAN), another wide area network (WAN) or a combination thereof, and may include one or more network devices similar to the network device 252. The network 554 may also include various wired and wireless connections to communicatively couple the charger 500 to the server 550 and peripheral device 556. The wireless microcontroller 540 may include, for example, a Wi-Fi radio including hardware, software, or a combination thereof enabling wireless communications according to the Wi-Fi protocol. In other embodiments, the wireless microcontroller 540 is configured to communicate with the server 550 via the network 554 using other wireless communication protocols. Regardless of the protocol, the wireless microcontroller 540 includes a wireless transceiver to enable wireless communications. The wireless microcontroller 540 and processor 514 may be collectively referred to as an electronic controller or processor of the charger 500. The electronic controller may execute software, which may be stored in the memory 509 or a memory of the wireless microcontroller 540, to carry out the functionality of the charger 500 described herein.

Although separately labeled and described, the server 550 may be the same server (in whole or part) as the server 250, the network 554 may be the same network (in whole or part) as the network 254, and the peripheral device 556 may be the same peripheral device (in whole or part) as the smart phone 256.

Similar to the communications described above between the peripheral device (e.g., the smart phone 256) and the accessory device 200 when the accessory device 200 is coupled with the garage door opener 100, communication may occur between the accessory device 200 and the peripheral device 556 via the charger 500. Such communications may include the communication of a data set including at least identifier (ID) data, settings data, and status data, from each of the different accessory devices 200 coupled to the charger 500 to the peripheral device 556 via the wireless microcontroller 540. In one communication method, the charger 500 acts as an intermediary communication device or pass through device - that is, the wireless microcontroller 540 determines the accessory 200 is received in the port and understands data sets that it sends and receives is divided into categories (e.g., unique identifier, status, settings), but does not actually process or 'understand' the data contained within the data set. Rather, it simply routes the data set associated with each connected port to the peripheral device 556 via the server 550. This, for example, allows the charger 500 to receive one of multiple different accessories in a single port, and allows each accessory device 200 to be moved from a first port to another port (when the charger 500 includes multiple accessory device ports).

For example, the server 550 may maintain data sets for each accessory device. The charger 500 receives data from the accessory device 200 and communicates the data to the server 550 to update the data set. In turn, the server 550 communicates (e.g., based on a push or pull operation) the updated data set to the peripheral device 556 via the network 554. Likewise, the peripheral device 556 may generate (e.g., based on user input) data that is transmitted, via the network 554, to the server 550 to update the data set associated with the accessory device 200. The server 550, in turn, communicates (e.g., based on a push or pull operation) the updated data set to the accessory device 200 via the network 554 and the wireless microcontroller 540. In some embodiments, the charger 500 directly communicates information between the accessory device 200 and the peripheral device 556 via the network 554, rather than via the server 550.

The communications between the peripheral device 556 and the accessory device 200 enable the peripheral device 556 to determine the identity of the accessory device 200 (based on obtained ID data), to determine the status and settings of the accessory device 200 (based on received status data and settings data), and to control the accessory device 200 (e.g., to turn on/off the device and to vary settings and thresholds of the device based on sending settings data).

In other embodiments, however, the charger is not configured to communicate with the peripheral device 556. For example, the wireless microcontroller 540 may not be included in some embodiments. In such embodiments, either the accessory device 200 or the charger 500 includes user input devices to control the operating state of the accessory device 200. The charger 500 may further obtain status information from the accessory device 200 coupled thereto and provide the status information to a user via the display 506.

FIG. 10 also illustrates one exemplary block diagram of the accessory devices 200 in detail. FIG. 10 illustrates two accessory devices 200, each being similarly configured. Accordingly, the description of one of the accessory devices 200 similarly applies to both accessory devices 200. The accessory devices 200 may be a speaker (e.g., the speaker 212), a fan, an extension cord reel, an environmental sensor, a flashlight, or a security camera, among others. As illustrated, the accessory device 200 includes a controller 1200 having a memory 1205 and an electronic processor 1210, one or more sensors 1215 (e.g., temperature sensors, humidity sensors, and carbon monoxide sensors, etc.) and one or more loads 1220 (e.g., indicators, speakers, cameras, lights, motors, etc.) coupled by a bus 1225. The controller 1200 is coupled to the charger 500 via the electrical mounting interface 400 to enable data communications between the controller 1200 and the charger 500 and to provide power to the accessory 200. The controller 1200 executes software, which may be stored in memory 1205, to carry out the function of the accessory device 200 described herein (e.g., to receive, store data from the sensor(s) 1215, to control the load(s) 1220, to communicate data to and receive data from the charger 500). The particular sensors 1215, loads 1220, and functionality of the controller 1200 varies depending on the type of accessory 200. The accessory device 200 may receive settings data from the peripheral device 556 via the charger 500, as described above. In response, the controller 1200 may store the settings data (e.g., in the memory 1205) and control the load(s) 1120, sensor(s) 1215, or both, in accordance with the settings data. For example, when the accessory device 200 is a fan, in response to received settings data from the peripheral device 556, the electronic processor 1210 may control a fan motor (an example of the load 1220) to turn on, off, or adjust speed based on the received settings data.

The accessory device 200 is configured to interface with the charger 500 in the same way that the accessory device 200 interfaces with the garage door opener 100. The mechanical mounting interface 300 of the accessory device 200 (see FIGS. 6-7) is configured to be coupled to the coupling interface 570 of the housing 508, and the electrical mounting interface 400 of the accessory device 200 (see FIGS. 6-7) is configured to be coupled to the communication interface 566 of the housing 508. In particular, the hooks 304 of the mechanical mounting interface 300 are received within the apertures 590 of the coupling interface 570, and the pair of projections 308 are received within the slots 582, the latch member 312 engages the catch 594, and the electrical mounting interface 400 electromechanically engages the communication interface 566. The projections 308 and the slots 582 assist with alignment of the electrical mounting interface 400 and the communication interface 566. When coupled, the accessory device 200 receives power from the charger 500 via a connection defined by the electrical mounting interface 400 and the communication interface 166. The accessory device 200 also sends data to and receives data from the charger 500 via a connection defined by the electrical mounting interface 400 and the communication interface 566.

FIG. 10 also illustrates one exemplary block diagram of the peripheral device 556 in further detail. As illustrated, the peripheral device 556 includes a communications interface 1150, a memory 1155, an electronic processor 1160, a display 1165, and user input/output 1170 coupled by bus 1175. The communication interface 1150 is coupled (wired and/or wirelessly) to the network 554 and enables the electronic processor 1160 (and, thereby, the peripheral device 556) to communicate with the server 550 (and, thereby, the charger 500 and the accessory device 200). The electronic processor 1160 executes software, which may be stored in the memory 1155, to carry out the functionality of the peripheral device 556 described herein (e.g., send data to and from the charger 500 and to control and monitor operation of the accessory device 200). The user input/output 1170 include one or more push buttons, toggle switches, speakers, and vibration generators for receiving user input and providing user output. In some embodiments, the display 1165 is a touch screen display and is part of the input/output 1170. The display provides visual output regarding the charger 500 and the accessory device 200.

FIG. 10 also illustrates an exemplary block diagram of the server 550. As illustrated, the server 550 includes a network communication interface 1315, a server memory 1305, and a server processor 1310 coupled by bus 1320. The network communication interface 1315 is coupled (wired and/or wirelessly) to the network 554 and enables the server processor 1310 (and, thereby, the server 550) to communicate with the charger 500 (and, thereby, the accessory device 200) and the peripheral device 556. The server memory 1305 stores the accessory information (e.g., the data set including the ID data, settings data, and status data for each of the accessory devices 200), as well as operational data and software. The server processor 1310 executes software, which may be stored in the memory 1305, to carry out the functionality of the server 550 described herein. For example, the server processor 1310 reads and writes the accessory information to the memory 1305. Although illustrated as a single server, the server 550 may be implemented by one or more servers co-located or located separately from one another and, for instance, coupled by various communication networks.

With reference to FIGS. 8A and 11, the battery pack 505 is coupled to the charger 500 via the battery receiving port 530. The battery receiving port 530 includes the electrical and mechanical connections of the battery pack 505 and the charger 500, including the battery terminals (see contacts 1390 of FIG. 11) and charger terminals for transmitting power and, in some instances, data; the battery receiving port 530 of the charger 500 described with respect to FIG. 8A is used to secure the battery pack 505 to the charger 500; and the portion of the battery pack 505 received in the battery receiving portion 530 (see insertion portion 1375 of FIG. 11).

With reference to FIGS. 11 and 12, the battery pack 505 includes battery cells 1350 and a battery controller 1355 having an electronic processor 1360 and a memory 1365. The electronic processor 1360 executes instructions stored in the memory 1365 to control the functionality of the battery pack 505 described herein, such as to control the charge and discharge of the battery cells 1350 (e.g., via switching elements (not shown)). The battery cells 1350 may provide a voltage output of about 18 volts, of another value in a range between 17 to 21 volts, or another value, such as about 12 volts, about 28 volts, about 36 volts, about 48 volts, another value or range between 12 to 48 volts, or another value. The term "about" may indicate a range of plus or minus 20%, 15%, 10%, 5%, or 1% from an associated value. The battery cells 1350 may have various chemistry types, such as lithium ion, a nickel cadmium, etc.

FIG. 11 illustrates an example of the battery pack 505 that may be coupled to the charger 500 via the battery receiving port 530. The battery pack 505 includes latches 1370 on either side of the pack for engaging the slots 548 of the battery receiving port 530 on the charger 500. The battery pack 505 further includes an insertion portion 1375 that is received by the battery receiving portion 530 of the charger 500. The insertion portion 1375 includes a top support portion 1380 having a stem 1385 extending vertically from the top support portion 1380. The stem 1385 has contacts 1390 that supply power to the charger 500 and may communicate data between the charger 500 and the battery pack 505. The battery pack 505 further includes a fuel gauge 1395 that indicates a state of charge of the battery pack. The battery pack 505 may be a power tool battery pack configured to power a power tools (e.g., drills/drivers, impact drills/drivers, hammer drills/drivers, saws, and routers) having a battery receiving portion similar to the battery receiving portion 530.

As noted above, although the charger 500 is illustrated as having one port 562, in some embodiments, the charger 500 includes more than one port 562 for coupling to a plurality of the battery packs 505. In such embodiments, the charger 500 is operable to serve as a communication interface to the network 554 such that each of the accessory devices 200, when coupled to the charger 500, may communicate with the server 550 and peripheral device 556 for monitoring and control as described above.

Thus, embodiments described herein provide, among other things, a method of operating an accessory device system including a garage door opener, a charger, and one or more accessory devices whereby a first accessory device of the one or more accessory devices may be coupled to the garage door opener, operated based on power from the garage door opener, removed from the garage door opener, coupled to the charger, and then operated based on power from the charger.

In another embodiment, an accessory device system includes a garage door opener, a charger, and one or more accessory devices whereby the garage door opener has a first accessory device port configured to couple to the one or more accessory devices and the charger has a second accessory device port configured to couple to the one or more accessory devices. The garage door opener is further configured to provide power to a first accessory device of the one or more accessory devices via the first accessory device port. The charger further includes a battery receiving portion configured to be selectively coupled to a battery pack and to charge the battery pack, and the charger is further configured to provide power to the first accessory device via the second accessory device port.

In another embodiment, an accessory device system includes a charger, a battery pack selectively coupled to a battery receiving portion of the charger to receive charging current, and a first accessory device coupled to an accessory device port of the charger. The charger further includes an electronic controller having a wireless transceiver and operable to communicate with a peripheral device to one or more of provide identity and status information regarding the first accessory device and to receive settings data to control the first accessory device. The charger receives the identity and status information from the first accessory device, and provides the settings data to the first accessory device to control the first accessory device. In some instances, the peripheral device and the charger communicate via a network and server, and the charger communicates wirelessly with the network via the wireless transceiver.

In another embodiment, a method of operating an accessory device system is provided where the system includes a charger, a battery pack selectively coupled to a battery receiving portion of the charger to receive charging current, and a first accessory device coupled to an accessory device port of the charger. The method further includes the charger receiving identity and status information from the first accessory device, and communicating, by an electronic controller of the charger having a wireless transceiver, with peripheral device to provide the identity and status information regarding the first accessory device to the peripheral device. The method further includes communicating, via the wireless transceiver of the charger, with the peripheral device to receive settings data to control the first accessory device, and providing the settings data to the first accessory device to control the first accessory device. In some instances, the peripheral device and the charger communicate via a network and server, and the charger communicates wirelessly with the network via the wireless transceiver.

Various features of the invention are set forth in the following claims.

## Claims

1. An accessory device system comprising:
an accessory device;
a garage door opener including a first accessory device port configured to couple to the accessory device and provide power to the accessory device via the first accessory device port; and
a charger including
a second accessory device port configured to couple to the accessory device, and
a battery receiving portion configured to be selectively coupled to a battery pack and to provide charging power to the battery pack,
wherein the charger is configured to provide power to the accessory device via the second accessory device port.

2. The accessory device system of claim 1, wherein the battery pack is a power tool battery pack having a battery cell with at least one selected from the group consisting of nickel cadmium chemistry and lithium ion chemistry.

3. The accessory device system of claim 1 or claim 2, wherein the charger further includes an electronic controller having a wireless transceiver and configured to:
communicate with a peripheral device to one or more of provide identity and status information regarding the accessory device and to receive settings information to control the accessory device,
receive the identity and status information from the accessory device, and
provide the settings information to the accessory device to control the accessory device.

4. The accessory device system of any preceding claim, wherein the charger further includes an AC outlet port and a DC outlet port, or
wherein the charger further includes a third accessory device port configured to couple to a second accessory device, and the charger is configured to provide power to the second accessory device via the third accessory device port.

5. The accessory device system of any preceding claim, wherein the charger further includes an electronic controller having a wireless transceiver and configured to:
communicate with a peripheral device to one or more of provide identity and status information regarding the accessory device and the second accessory device and to receive settings information to control the accessory device and the second accessory device,
receive the identity and status information from the accessory device and the second accessory device, and
provide the settings information to the accessory device and second accessory device to control the accessory device and the second accessory device.

6. The accessory device system of any preceding claim, wherein the accessory device is at least one selected from the group consisting of a wireless speaker, a fan, or a light, or
wherein the accessory device is a first accessory device and the system further comprises a second accessory device configured to couple to the first accessory device port and to the second accessory device port.

7. A method of operating an accessory device system including a garage door opener, a charger, and an accessory device, the method comprising:
receiving, by a first accessory device port on the garage door opener, the accessory device;
providing, by the garage door opener, power to the accessory device via the first accessory device port;
disconnecting, by the first accessory device port, from the accessory device;
receiving, by a second accessory device port on the charger, the accessory device; and
providing, by the charger, power to the accessory device via the second accessory device port.

8. The method of claim 7, further comprising:
receiving, by a battery receiving portion of the charger, a battery pack; and
charging, by the charger, the battery pack.

9. The method of claim 7 or 8, wherein the battery pack is a power tool battery pack having a battery cell with at least one selected from the group consisting of nickel cadmium chemistry and lithium ion chemistry.

10. The method of any one of claims 7 to 9, further comprising:
receiving, by a third accessory device port on the charger, a second accessory device after disconnecting the accessory device; and
providing, by the charger, power to the second accessory device via the third accessory device port.

11. The method of any one of claims 7 to 10, wherein accessory device is at least one selected from the group consisting of a wireless speaker, a fan, or a light.

12. A method of operating an accessory device system including an accessory device, the method comprising:
receiving the accessory device by an accessory device port on a charger that is portable and non-motorized;
providing, by the charger, power to the accessory device via the accessory device port;
receiving, via the charger, identity and status data from the accessory device;
sending, by an electronic controller of the charger having a wireless transceiver, the identity and status data regarding the accessory device to a peripheral device;
receiving, by the electronic controller, settings data regarding the accessory device from the peripheral device; and
providing, via the charger, the settings data to the accessory device to control the accessory device.

13. The method of claim 12, further comprising:
receiving, by a battery receiving portion of the charger, a battery pack; and
charging, by the charger, the battery pack.

14. The method of claim 12 or 13, wherein the battery pack is a power tool battery pack having nickel cadmium cell chemistry or lithium ion chemistry, or
wherein the accessory device is a wireless speaker, a fan, or a light, and the identity data indicates that the accessory device is a wireless speaker, a fan, or a light, or
wherein the peripheral device and the charger communicate via a network and server, or
wherein the charger communicates wirelessly with the network via the wireless transceiver.

15. The method of any one of claims 12 to 14, further comprising:
disconnecting, by the accessory device port, from the accessory device;
receiving, by the accessory device port, a second accessory device;
providing, by the charger, power to the second accessory device via the accessory device port;
receiving, by the charger via the accessory device port, second identity and status data from the second accessory device;
sending, by the electronic controller, the second identity and status data regarding the second accessory device to the peripheral device;
receiving, by the electronic controller, second settings data regarding the second accessory device from the peripheral device; and
providing, via the charger, the second settings data to the second accessory device to control the second accessory device.
